# EUROPEAN PATENT SPECIFICATION

(11) **EP 2 960 953 B1**
(45) Date of publication and mention of the grant of the patent: **11.04.2018**
(21) Application number: 14173789.0
(22) Date of filing: 25.06.2014
(51) Int. Cl.: H01L 35/30, F28F 3/08, F28D 7/00, F28D 9/00

(54) **Plate heat exchanger assembly and a frame to be used in such assembly**
Plattenwärmetauscheranordnung und Rahmen zur Verwendung in einer derartigen Anordnung
Ensemble échangeur de chaleur à plaques et cadre destiné à être utilisé dans un tel ensemble

(43) Date of publication of application: 30.12.2015
(73) Proprietor: Alfa Laval Corporate AB, 221 00 Lund (SE)
(72) Inventor: Andreasson, Fredrik, SE-247 31 Södra Sandby (SE); Strömer, Fredrik, SE-244 36 Kävlinge (SE); Ross, Martin, SE-275 33 Sjöbo (SE)
(74) Representative: Alfa Laval Attorneys

(56) References cited:
- EP-A1- 0 450 822
- DE-A1-102007 063 196
- FR-A1- 2 702 829
- JP-A- H11 340 520
- US-A- 5 584 183
- US-A1- 2004 206 386
- US-A1- 2005 194 034

## Description

### Technical Field

The invention relates to a plate heat exchanger assembly, a frame to be included in such assembly and the use of such assembly in a combustion engine for extracting electric power from exhaust gases.

### Background Art

The general concept behind a heat exchanger is to heat or cool a first fluid by transferring heat between it and a second fluid. One specific type of a heat exchanger is a so called plate heat exchanger wherein a series of plates are alternately stacked one on top of the other to form a plate package forming parallel flow channels with alternating hot and cold fluids. The plates may be joined by e.g. welding, brazing or bonding thereby forming a standalone plate package. Alternatively, the plates may be loosely stacked and arranged in a frame comprising two opposing end plates compressing the heat exchanging plates. In the latter case the dimensioning compression pressure is essential to be able to withstand thermal movements while at the same time allowing no leaks. The latter is of special importance since the internal pressures and temperatures of the fluids in some cases may be very high.

It is known from e.g. US2013/0213449A1 or US2005/0194034A1 to integrate thermoelectric devices between the parallel flow channels and thermally couple them to the cold and warm sides respectively to thereby generate electricity.

For an optimal operation, the thermoelectric devices require specific conditions. There must be available space between the hot and cold sides that can accommodate the devices and also allow for wiring and electrical connection. Further, the available space should be flat to ensure proper contact between the plates and the thermoelectric devices. Further, pressure must be applied to the thermoelectric devices to reach proper contact resistance while simultaneously allowing thermal expansion of the heat exchanging plates to guarantee lifetime expectancy. The provision of a proper contact pressure is of importance since the thermoelectric devices are designed with a dimensioning contact pressure for an optimal operation. It has however been noted that the compression pressure required to resist leaks is different from the pressure required for an optimal operation of the thermoelectric devices.

### Summary

It is an object of the invention to at least partly overcome one or more of the above-identified limitations of prior art. In particular, it is an object to provide a plate heat exchanger assembly which allows different pressure zones accommodating the different requirements in terms of leaks and contact pressure.

Another object is to fulfill these requirements while at the same time keeping the components and the manufacturing process as simple as possible.

To solve these objects a plate heat exchanger assembly is provided comprising: a plate package comprising a first and second set of heat exchanging panels, each comprising a fluid supply area and a heat transfer area, the panels being alternately stacked one on top of the other, and wherein at least one thermoelectric device is arranged between two adjacent heat exchanging panels and in thermal contact with the heat transfer area of one heat exchanging panel from each of the first and second set of heat exchanging panels; and a frame comprising a first end portion and second end portion, each end portion comprising a first section and a second section and the first and a second end portions being arranged on opposite sides of the plate package, the first sections being arranged for compression across the fluid supply areas of the heat exchanging panels and the second sections being arranged for compression across the heat transfer areas of the heat exchanging panels, and a first set of tensioning means extending between the first sections of the first and second end portions and a second set of tensioning means extending between the second sections of the first and second end portions, the first and second sections of the first and second end portions respectively being mutually movable.

A thermoelectric device as such is well known in the art and acts as a thermoelectric generator, also known in the art as a TEG. The thermoelectric device is a semiconductor-based electronic component that generates power by utilizing a temperature gradient and heat flow in order to produce useful power output. By integrating this kind of thermoelectric devices in the plate heat exchanging assembly, waste or by-product heat flow generated by some other activity may be used to generate power.

By the first and second end portions of the frame being divided into two sections the stacked first and second sets of heat exchanger panels will be compressed as one unit while meeting different design requirements of the components included in the plate package. More precisely, the fluid supply area may be provided with a compression pressure sufficient for the provision of a leakage proof operation although the heat exchanging panels are loosely stacked without any joining. The compression pressure may be set according to dimensioning parameters of sealings, expected fluid pressures and fluid temperatures etc. Further, the heat transfer area may be provided with a compression pressure specifically designed to meet the optimal contact pressures of the thermoelectric devices in order of providing an optimal operation thereof with an optimal efficiency. This is of special importance since thermoelectric devices are designed with a specific contact pressure to operate optimally. The contact pressure is also of importance in terms of expected lifetime and warranty.

Further, by the first and the second sections of the first and the second end portions of the frame being mutually movable, the frame as a whole is allowed to accommodate thermal movements, which movements may be expected to differ across the frame during operation. By way of example, in case the heat exchanger assembly is intended to operate with one fluid constituted by a liquid refrigerant such as cooler water from a combustion engine while the other fluid is constituted by a gaseous fluid such as hot exhaust gases, the temperature of the exhaust gases may typically be lowered from an inlet temperature of about 650 °C to an outlet temperature of about 250 °C while passing the heat exchanger assembly. This causes substantial temperature differences across the assembly, which causes different temperature related movements of the plate package, the frame and its components. By the frame comprising two sets of tensioning means, the thermal movements may be accommodated differently across the fluid supply area and the heat transfer area, respectively.

The second set of tensioning means may comprise elastic compression means. By the elastic compression means, the contact pressure between the heat exchanging panels and the thermoelectric devices may be kept essentially constant while still accommodating thermal movements. Thereby an optimal operation of the thermoelectric devices with a high efficiency may be ensured. Further, by using elastic compression means the compression force across the thermoelectric devices and the heat transfer area may be easily determined. By using elastic compression means having a well known characteristic the compression force may be determined simply by measuring the degree of compression of the elastic compression means.

The second set of tension means may be provided as tension bars, each tension bar being provided with an elastic compression means.

The elastic compression means may be integrated in the second sections of the second end portions. The elastic compression means may be arranged on either surface of the second end portions, i.e. facing the plate package or facing away from the plate package.

According to one embodiment there is no metallic contact between the first and the second sections of the first and second end portions of the frame. Thereby the heat transfer between the first and second sections may be limited. To further limit heat transfer, an insulation may be arranged between the first and the second sections of the first and the second end portions of the frame.

The heat exchanging panels may each comprise a first and a second plate arranged one on top of the other and mutually joined to define a flow channel there between, said flow channel being provided with a turbulator extending at least partly across the heat transfer area of the heat exchanging panel. By arranging a turbulator between the two plates rather than providing the wall portions of the first and second plates with a pressed corrugated profile, the individual heat exchanger panel will be extremely rigid, thereby further restricting thermal movements. Further, the wall portions of the heat exchanging panels forming contact surfaces with the thermoelectric devices may be made essentially be flat, thereby ensuring and improving the contact and heat transfer between the thermoelectric devices and the heat exchanging panels.

The first and second plates and the turbulator may together form an integrally joined structure. The joining may be made in the same operation as used when joining the plates making up the heat exchanging panels, i.e. welding, brazing or bonding.

The fluid supply area may comprise a fluid inlet opening and a fluid outlet opening arranged on opposite sides of the heat transfer area. Thus, the fluid supply area may be divided.

An insulation may be arranged between the heat exchanging panels of the plate package, said insulation comprising a through opening receiving the at least one thermoelectric device. The insulation may by way of example be made of a fibrous material, a rubber based material, a composite material or a plastics material. The insulation prevents heat losses between the heat exchanging panels by preventing direct contact there between, while at the same time allowing a direct contact between the thermoelectric device and the heat exchanging panel. Accordingly, the efficiency of the thermoelectric device may be improved.

The thermoelectric devices may be thermoelectric generators.

According to another aspect, the invention relates to a frame for a plate heat exchanger in the form of a plate package comprising a set of first and second heat exchanging panels, each panel comprising a fluid supply area and a heat transfer area, wherein at least one thermoelectric device is arranged between two adjacent heat exchanging panels, wherein the frame comprises a first end portion and second end portion, each end portion comprising a first section and a second section, the first and second end portions being arranged on opposite sides of the plate package, the first end sections being arranged for compression across the fluid supply areas of the heat exchanging panels and the second end sections being arranged for compression across the heat transfer areas of the heat exchanging panels, and the frame further comprising a first set of tensioning means extending between the first sections of the first and second end portions and a second set of tensioning means extending between the second sections of the first and second end portions, wherein the first and second sections of the first and second end portions are respectively mutually movable.

The frame has in all relevant aspects the same design as the frame included in the heat exchanger assembly discussed above and offers the same advantages. To avoid undue repetition, reference is made to the discussion given above.

According to yet another aspect, the invention relates to the use of a plate heat exchanger assembly with the features given above in a combustion engine for extracting electric power from exhaust gases.

Still other objectives, features, aspects and advantages of the invention will appear from the following detailed description as well as from the drawings.

### Brief Description of the Drawings

Embodiments of the invention will now be described, by way of example, with reference to the accompanying schematic drawings, in which
Fig. 1 is a perspective view of a plate heat exchanger assembly according to one embodiment of the invention.
Fig. 2 is a schematic perspective view of the lower plate forming a part of a heat exchanging panel to be used in the assembly.
Fig. 3 is a schematic perspective view disclosing a plurality of heat exchanger panels arranged one on top of the other with intermediate thermoelectric devices.
Fig. 4 is a highly schematic view disclosing an alternative position of the compression means.

### Detailed description

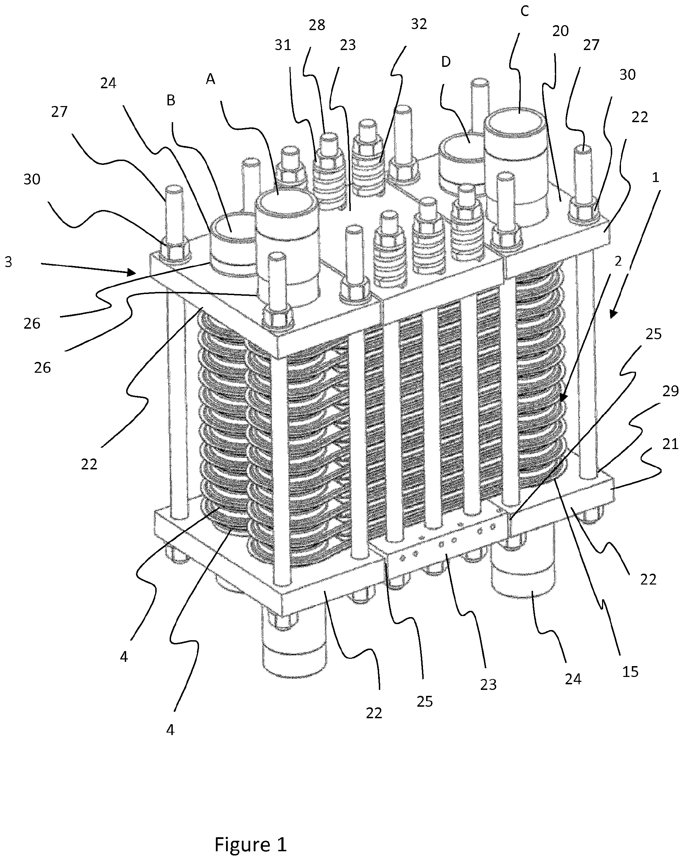

With reference to Fig. 1 a plate heat exchanger assembly 1 according to one embodiment of the invention is illustrated. The plate heat exchanger assembly 1 comprises in general a plate package 2 arranged in a frame 3. The plate package 2 which as such is well known in the art comprises a plurality of heat exchanging panels 4 which are alternately stacked one on top of the other.

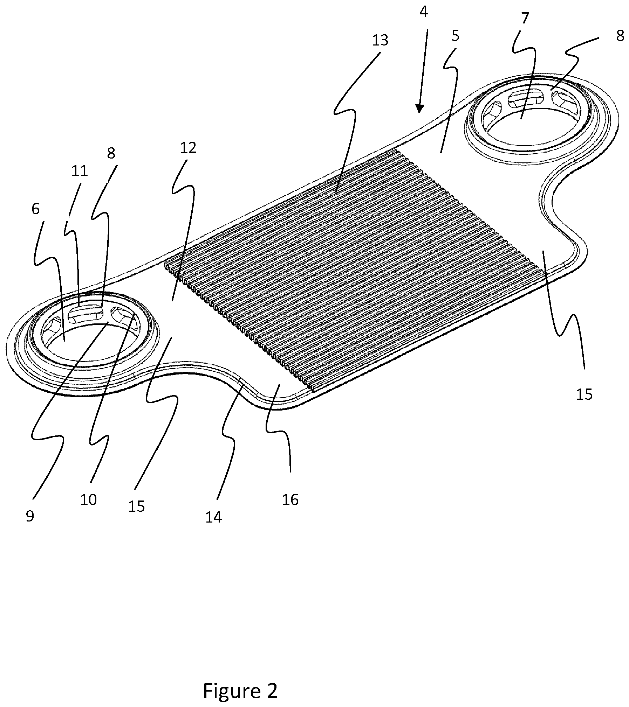

Now turning to Fig. 2 one example of an individual heat exchanging panel 4 will be discussed. The heat exchanging panel 4 comprises a first and a second plate 5 arranged one on top of the other. For illustrative purposes, only the lower plate 5 is disclosed. The non disclosed upper plate has the same mirrored design.

The lower and upper plates 5 are typically formed by thin pressed metal sheet and have a through inlet opening 6 and a through outlet opening 7. In the disclosed embodiment, the inlet and outlet openings 6, 7 are arranged in opposite lobe shaped corner portions. It goes without saying that the invention should not be restricted to the disclosed geometry. A fluid distributor 8 is arranged in the inlet and outlet openings 6, 7 respectively. The fluid distributor 8 has the form of a ring 9 provided with a circumferential wall portion 10. The circumferential wall portion 10 is provided with a plurality of through distributing holes 11. The fluid distributors 8 are arranged to distribute fluid across the plate 5. The fluid distributors 8 serve yet another purpose in that they provide an axial reinforcement of the heat exchanging panel 4 around the inlet and outlet openings 6, 7 during operation.

In the disclosed embodiment the plate 5 has an essentially flat major surface 12 extending between the inlet and outlet openings 6, 7.

A turbulator 13 is arranged on the essentially flat major surface 12. In the disclosed embodiment the turbulator 13 is formed as a waffled sheet metal structure forming longitudinal channels extending along the longitudinal extension of the lower plate in a direction from the inlet opening 6 to the outlet opening 7. It goes without saying that the design of the turbulator 13 may be different with remained function.

The plate 5 is provided with a circumferential ridge 14 forming a supporting contact surface against the upper non-disclosed upper plate to be mounted thereon.

In order of forming an individual heat exchanging panel 4, a lower plate 5 of the type disclosed above is provided with the fluid distributor 8 in the inlet and outlet openings 7, 8 and a turbulator 13 and then an upper, non-disclosed plate is arranged on top thereof. The upper and lower plates 5, together with the fluid distributors 8 and the turbulator 13 are joined by welding, brazing or bonding, thereby forming an integrally joined heat exchanging panel 4 with two essentially flat opposing major surfaces delimiting an essentially flat flow channel there between extending from the inlet opening 6, via the through openings 11 in the circumferential wall portion of the distributor 8, across the major surface of the panel via the turbulator towards the through holes of the distributor 8 of the outlet opening 7 where it will be free to exit the heat exchanging panel 4.

The heat exchanging panel 4 may imaginary be divided into two fluid supply areas 15 and a heat transfer area 16. The fluid supply areas 15 extend across and around the inlet and outlet openings 6, 7 respectively whereas the heat transfer area 16 extends there between. It goes without saying that there is no distinct boundaries for the two areas and that their surface extensions depend on the overall design of the panel 4. Thus, the fluid supply areas 15 and the heat transfer area 16 may be regarded as imaginary areas. In the disclosed embodiment the heat transfer area 16 will be formed by the essentially rectangular flat major surface 12 extending between the two lobe shaped inlet and outlet portions which thereby will define two fluid supply areas 15 on opposite sides of the heat transfer area 16.

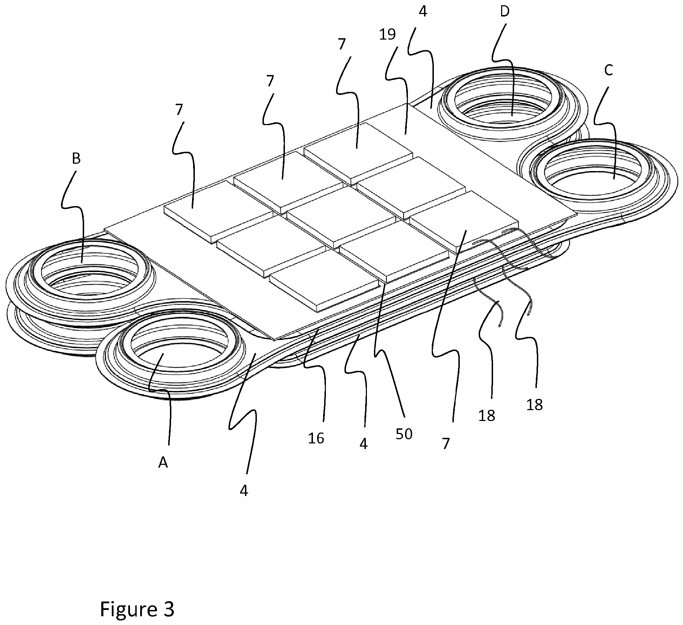

Now turning to Fig. 1 and 3, in order of forming a plate package 2 intended for two fluids, two sets of heat exchanging panels 4 are required, which panels as such may be identical. The first set of panels are arranged for a first fluid whereas the second set of panels are arranged for a second fluid. Panels 4 from the two sets are alternately stacked one on top of the other in a manner that the inlet openings 6 and the outlet openings 7 of panels 4 of the first set are aligned, and that the inlet openings 6 and the outlet openings 7 of panels 4 of the second set are aligned, thereby forming two through inlet channels A, B and two outlet channels C, D along the height of the plate package 2. Thereby a through inlet channel A and a through outlet channel C for a first fluid and a through inlet channel B and a through outlet channel C for a second fluid will be formed. Said channels A, B, C, D are in communication with the respective flat flow channels delimited between two adjacent joined plates 5 making up the individual heat exchanging panels 4. Sealings (not disclosed) are preferably arranged between the panels 4 at least around the inlet and outlet openings 6, 7 thereof.

In the thus resulting stacked plate package 2 two fluid systems will be provided - a first fluid system allowing a first fluid to flow from the first inlet channel A, through all panels in the first set of heat exchanging panels and out via the first outlet channel C, and a second fluid system allowing a second fluid to flow from the second inlet channel B, through all panels in the second set of heat exchanging panels and out via the second outlet channel D.

Now turning to Fig. 3 at least one thermoelectric device 17 is arranged between two adjacent heat exchanging panels 4 and in thermal contact with the heat transfer area 16 of one heat exchanging panel from each of the first and second sets of heat exchanging panels. In the disclosed embodiment nine thermoelectric devices 17 are arranged between each set of panels 4. It goes without saying that the number and pattern may vary. In the disclosed embodiment, the thermoelectric devices 17 are provided with wires 18 extending outside the plate package. To facilitate the illustration, only a some of the thermoelectric devices 17 are provided with wires 18. The characteristics of the thermoelectric devices 17 may be the same throughout the plate package 2, or differ as seen from a position adjacent the fluid supply area 15 comprising the inlet opening 6 to a position adjacent the fluid supply area 15 comprising the outlet opening 7.

In order of improving thermal transfer from the heat exchanging panels 4 to the thermoelectric devices 17 and thereby ensuring a high efficiency of the latter an insulation 19 may be arranged between the heat exchanging panels 4. The insulation 19 comprises through holes 50 receiving the thermoelectric devices 17 whereby the thermoelectric devices 17 will be in direct contact with the heat exchanging panels 4. Thereby the insulation will restrict heat transfer between the heat exchanging panels 4 while at the same time making sure that the heat instead will transfer between the panels 4 via the thermoelectric devices generating electrical power. The insulation 19 may by way of example be a fibrous material, a plastic material or a composite material.

Now turning anew to Fig.1, the plate package 2 is arranged in a frame 3. The frame 3 comprises a first end portion 20 and second end portion 21 arranged on opposite sides of the plate package 2. Each end portion 20, 21 is divided into first and second sections 22, 23. The first sections 22 are arranged across the fluid supply areas 15 of the plate package 2 and the second end sections 23 are arranged across the heat transfer areas 16 of the heat exchanging panels 4.

To facilitate fluid supply to the plate package 4, the inlet and outlet openings of the panels 4 may be provided with connection pipes 24 extending through the first sections 22.

The first and second sections 22, 23 of the first and second end portions 20, 21 are in the disclosed embodiment separated by a gap 25. Thus there is no metallic contact there between. Accordingly, the first and second sections 22, 23 are mutually movable allowing the two sections to apply a different degree of compression across the plate package 2. Further, by such gap 25 no direct heat transfer and thereby heat losses will take place between the first and second sections 22, 23. The gap 25 may be provided with an insulation (not disclosed) to further limit heat transfer there between. Accordingly heat losses from the heat transfer area 16 to the fluid supply area 15 may be reduced. Instead the heat transfer will take place from the heat exchanging panels 4 to the thermoelectric devices 17 to thereby improve the efficiency of the thermoelectric devices 17. Further, it is preferred that there is a radial gap 26 between the first sections 22 and the connecting pipes 24 of the plate package 2. Such radial gap 26 contributes to prevention of heat losses in the fluid supply area 15.

A first set of tensioning means 27 extend between the opposing first sections 22 of the first and second end portions 20, 21. In the disclosed embodiment the first set of tensioning means 27 are arranged as four tension bars extending via through holes 29 in the first sections 22. The tensioning means are provided with locking means 30 in the form of washers and nuts. The locking means 30 are tensioned with a locking force which is sufficient to provide a leak proof compression of the fluid supply areas 15 of the plate package 2 during operation. Although not disclosed it may be possible to provide the first set of tensioning means with elastic compression means.

A second set of tensioning means 28 extend between the opposing second sections 23 of the first and second end portions 21. In the disclosed embodiment the second set of tensioning means 28 are arranged as tension bars extending via through holes in the second sections 23. The second tensioning means 28 are provided with locking means 31 in the form of washers and nuts. Further elastic compression means 32 are arranged between the locking means 31 and the second section 23 of the upper second end portion 21. Also although not disclosed, the second section of the opposite lower end portion may be provided with corresponding elastic compression means. The elastic compression means 32 may by way of example be helical springs.

The locking means 31 of the second section 23 are tensioned with a locking force which is sufficient to provide the dimensioned contact pressure between the heat exchanging panels 4 and the thermoelectric devices 17. Any thermal movement during operation across the heat transfer area 16 may be accommodated by the elastic compression means 32. Thereby a more or less constant contact pressure between the thermoelectric devices 17 and the heat exchanging panels 4 may be provided during operation.

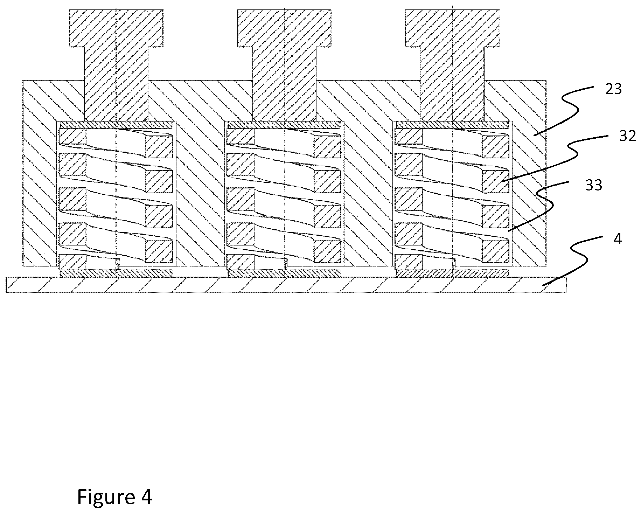

Fig. 4 discloses highly schematically an alternative embodiment of the second section 23 wherein the elastic compression means 32 are received in a recess 33 in the second section 23 which recess is facing the highly schematically disclosed plate package 4.

The heat exchanger assembly according to the present invention may be used to generate electric power from the exhaust gases of a combustion agent. The first set of heat exchanging panels may be connected to the cooler system circulating refrigerant such as cooler water there through, and the second set of heat exchanging panels may be connected to the outlet of hot exhaust gas generated by the combustion engine. The exhaust gas flow may be re-circulated exhaust gas in an EGR-system used for reduction of nitrogen oxide emissions. Trials have shown that it may be possible to generate 0.5kW while reducing the temperature of the re-circulating exhaust gas from about 650 °C to 250 °C.

From the description above follows that, although various embodiments of the invention have been described and shown, the invention is not restricted thereto, but may also be embodied in other ways within the scope of the subject-matter defined in the following claims.

## Claims

1. A plate heat exchanger assembly (1) comprising:
a plate package (2) comprising a first and second set of heat exchanging panels (4), each comprising a fluid supply area (15) and a heat transfer area (16), the panels (4) being alternately stacked one on top of the other, and wherein at least one thermoelectric device (17) is arranged between two adjacent heat exchanging panels (4) and in thermal contact with the heat transfer area (16) of one heat exchanging panel from each of the first and second set of heat exchanging panels; and
a frame (3) comprising a first end portion (20) and a second end portion (21), each end portion comprising a first section (22) and a second section (23) and the first and second end portions (20, 21) being arranged on opposite sides of the plate package (2), the first sections (22) being arranged for compression across the fluid supply areas (15) of the heat exchanging panels (4) and the second sections (23) being arranged for compression across the heat transfer areas (16) of the heat exchanging panels (4),
and a first set of tensioning means (27) extending between the first sections (22) of the first and second end portions (20, 21) and a second set of tensioning means (28) extending between the second sections (23) of the first and second end portions (21), **characterised in that** the first and second sections (22, 23) of the first and second end portions (20, 21) respectively being mutually movable.

2. A plate heat exchanger assembly according to claim 1, wherein the second set of tensioning means (28) comprises elastic compression means (32).

3. A plate heat exchanger assembly according to any of the preceding claims,
wherein the second set of tensioning means (28) is provided as tension bars, each tension bar being provided with an elastic compression means (32).

4. A plate heat exchanger assembly according to any of claims 2-3, wherein the elastic compression means (32) are integrated in the second sections (23) of the second end portions (21).

5. The plate heat exchanger assembly according to any of the preceding claims, wherein there is no metallic contact between the first and the second sections (22, 23) of the first and second end portions (20, 21) of the frame (3).

6. The plate heat exchanger assembly according to any of the preceding claims, wherein the heat exchanging panels (4) each comprises a first and a second plate (5) arranged one on top of the other and mutually joined to define a flow channel there between, said flow channel being provided with a turbulator (13) extending at least partly across the heat transfer area (16) of the heat exchanging panel (4).

7. The plate heat exchanger assembly according to claim 6, wherein the first and second plates (5) and the turbulator (13) together form an integrally joined structure.

8. The plate heat exchanger assembly according to any of the preceding claims, wherein the fluid supply area (15) comprises a fluid inlet opening (6) and a fluid outlet opening (7) arranged on opposite sides of the heat transfer area (16).

9. A plate heat exchanger assembly according to any of the preceding claims,
wherein an insulation(19) is arranged between the heat exchanging panels (4) of the plate package (2), said insulation (19) comprising a through opening (50) receiving the at least one thermoelectric device (17).

10. A plate heat exchanger assembly according to any of the preceding claims,
wherein the thermoelectric devices (17) are thermoelectric generators.

11. A frame (3) for a plate heat exchanger in the form of a plate package (2) comprising a set of first and second heat exchanging panels (4), each panel comprising a fluid supply area (15) and a heat transfer area (16), wherein at least one thermoelectric device (17) is arranged between two adjacent heat exchanging panels (4), wherein the frame (3) comprises a first end portion (20) and a second end portion (21), each end portion comprising a first section (22) and a second section (23),
the first and second end portions (20, 21) being arranged on opposite sides of the plate package (2), the first sections being arranged for compression across the fluid supply areas (15) of the heat exchanging panels (4) and the second sections (23) being arranged for compression across the heat transfer areas (16) of the heat exchanging panels (4), and the frame (3) further comprising a first set of tensioning means (27) extending between the first sections (22) of the first and second end portions (20, 21) and a second set of tensioning means (28) extending between the second sections (23) of the first and second end portions (20, 21), **characterised in that** the first and second sections (22, 23) of the first and second end portions (20, 21) are respectively mutually movable.

12. Use of a plate heat exchanger assembly according to any of claims 1-10,
in a combustion engine for extracting electric power from exhaust gases.

## Patentansprüche

1. Plattenwärmetauscheranordnung (1), die Folgendes umfasst:
einen Plattenstapel (2), der einen ersten und zweiten Satz von Wärmetauschpaneelen (4) umfasst, wobei jedes einen Flüssigkeitszuführungsbereich (15) und einen Wärmeübertragungsbereich (16) umfasst, wobei die Paneele (4) abwechselnd aufeinander gestapelt sind, und wobei mindestens eine thermoelektrische Einrichtung (17) zwischen zwei benachbarten Wärmetauschpaneelen (4) angeordnet ist und in thermischen Kontakt mit dem Wärmeübertragungsbereich (16) eines Wärmetauschpaneels von jedem des ersten und zweiten Satzes von Wärmetauschpaneelen steht; und
einen Rahmen (3), der einen ersten Endabschnitt (20) und einen zweiten Endabschnitt (21) umfasst, wobei jeder Endabschnitt einen ersten Teil (22) und einen zweiten Teil (23) umfasst und wobei der erste und zweite Endabschnitt (20, 21) auf entgegengesetzten Seiten des Plattenstapels (2) angeordnet sind, wobei die ersten Teile (22) zur Kompression über die Flüssigkeitszuführungsbereiche (15) der Wärmetauschpaneele (4) angeordnet sind und die zweiten Teile (23) zur Kompression über die Wärmeübertragungsbereiche (16) der Wärmetauschpaneele (4) angeordnet sind,
und einen ersten Satz von Spannmitteln (27), der sich zwischen den ersten Teilen (22) des ersten und zweiten Endabschnitts (20, 21) erstreckt, und einem zweiten Satz von Spannmitteln (28), der sich zwischen den zweiten Teilen (23) des ersten und zweiten Endabschnitts (21) erstreckt,
**dadurch gekennzeichnet, dass**
der erste und zweite Teil (22, 23) des ersten und zweiten Endabschnitts (20, 21) jeweils gemeinsam bewegbar sind.

2. Plattenwärmetauscheranordnung nach Anspruch 1, wobei der zweite Satz von Spannmitteln (28) elastische Kompressionsmittel (32) umfasst.

3. Plattenwärmetauscheranordnung nach einem der vorhergehenden Ansprüche, wobei der zweite Satz von Spannmitteln (28) als Zugstangen bereitgestellt wird, wobei jede Zugstange mit einem elastischen Kompressionsmittel (32) bereitgestellt wird.

4. Plattenwärmetauscheranordnung nach einem der Ansprüche 2 bis 3, wobei die elastischen Kompressionsmittel (32) in die zweiten Teile (23) der zweiten Endabschnitte (21) integriert sind.

5. Plattenwärmetauscheranordnung nach einem der vorhergehenden Ansprüche, wobei es keinen metallischen Kontakt zwischen dem ersten und zweiten Teil (22, 23) des ersten und zweiten Endabschnitts (20, 21) des Rahmens (3) gibt.

6. Plattenwärmetauscheranordnung nach einem der vorhergehenden Ansprüche, wobei die Wärmetauschpaneele (4) jeweils eine erste und eine zweite Platte (5) umfassen, die aufeinander angeordnet und gegenseitig verbunden sind, um einen Flusskanal dazwischen zu definieren, wobei der Flusskanal mit einem Wirbelerzeuger (13) bereitgestellt wird, der sich mindestens teilweise über den Wärmeübertragungsbereich (16) des Wärmetauschpaneels (4) erstreckt.

7. Plattenwärmetauscheranordnung nach Anspruch 6, wobei die erste und zweite Platte (5) und der Wirbelerzeuger (13) zusammen eine einstückig verbundene Struktur bilden.

8. Plattenwärmetauscheranordnung nach einem der vorhergehenden Ansprüche, wobei der Flüssigkeitszuführungsbereich (15) eine Flüssigkeitseinlassöffnung (6) und eine Flüssigkeitsausgangsöffnung (7) umfasst, die an entgegengesetzten Seiten des Wärmeübertragungsbereichs (16) angeordnet sind.

9. Plattenwärmetauscheranordnung nach einem der vorhergehenden Ansprüche, wobei eine Isolation (19) zwischen den Wärmetauschpaneelen (4) des Plattenstapels (2) angeordnet ist, wobei die Isolation (19) eine Durchlassöffnung (50) umfasst, die die mindestens eine thermoelektrische Einrichtung (17) aufnimmt.

10. Plattenwärmetauscheranordnung nach einem der vorhergehenden Ansprüche, wobei die thermoelektrischen Einrichtungen (17) thermoelektrische Generatoren sind.

11. Rahmen (3) für eine Plattenwärmetauscheranordnung in der Form eines Plattenstapels (2), die eine Reihe von ersten und zweiten Wärmetauschpaneelen (4) umfasst, wobei jedes Paneel einen Flüssigkeitszuführungsbereich (15) und einen Wärmetransferbereich (16) umfasst, wobei mindestens eine thermoelektrische Einrichtung (17) zwischen zwei benachbarten Wärmetauschpaneelen (4) angeordnet ist, wobei der Rahmen (3) einen ersten Endabschnitt (20) und einen zweiten Endabschnitt (21) umfasst, wobei jeder Endabschnitt einen ersten Teil (22) und einen zweiten Teil (23) umfasst, wobei der erste und zweite Endabschnitt (20, 21) an entgegengesetzten Seiten des Plattenstapels (2) angeordnet sind, wobei die ersten Teile zur Kompression über die Flüssigkeitszuführungsbereiche (15) der Wärmetauschpaneele (4) angeordnet sind und die zweiten Teile (23) zur Kompression über die Wärmeübertragungsbereiche (16) der Wärmetauschpaneele (4) angeordnet sind, und wobei der Rahmen (3) ferner einen ersten Satz von Spannmitteln (27) umfasst, der sich zwischen den ersten Teilen (22) der ersten und zweiten Endabschnitte (20, 21) erstreckt und einen zweiten Satz von Spannmitteln (28), der sich zwischen den zweiten Teilen (23) der ersten und zweiten Endabschnitte (20, 21) erstreckt, **dadurch gekennzeichnet, dass** der erste und zweite Teil (22, 23) des ersten und zweiten Endabschnitts (20, 21) jeweils gemeinsam bewegbar sind.

12. Verwendung einer Plattenwärmetauscheranordnung nach einem der Ansprüche 1 bis 10 in einem Verbrennungsmotor zur Gewinnung elektrischer Energie aus Abgasen.

## Revendications

1. Ensemble formant échangeur de chaleur à plaques (1), comprenant :
un empilement de plaques (2) comprenant des première et deuxième séries de panneaux échangeurs de chaleur (4), chaque panneau comprenant une zone d'alimentation de fluide (15) et une zone de transfert de chaleur (16), les panneaux (4) étant empilés de manière alternée les uns sur les autres, et dans lequel au moins un dispositif thermoélectrique (17) est agencé entre deux panneaux échangeurs de chaleur (4) adjacents et en contact thermique avec la zone de transfert de chaleur (16) d'un panneau échangeur de chaleur issu de chacune parmi les première et deuxième séries de panneaux échangeurs de chaleur ; et
un châssis (3) comprenant une première partie extrémité (20) et une deuxième partie extrémité (21), chaque partie extrémité comprenant une première section (22) et une deuxième section (23) et les première et deuxième parties extrémité (20, 21) étant agencées sur des côtés opposés de l'empilement de plaques (2), les premières sections (22) étant agencées en vue d'une compression sur les zones d'alimentation de fluide (15) des panneaux échangeurs de chaleur (4) et les deuxièmes sections (23) étant agencées en vue d'une compression sur les zones de transfert de chaleur (16) des panneaux échangeurs de chaleur (4),
et une première série de moyens de mise en tension (27) s'étendant entre les premières sections (22) des première et deuxième parties extrémité (20, 21) et une deuxième série de moyens de mise en tension (28) s'étendant entre les deuxièmes sections (23) des première et deuxième parties extrémité (21),
**caractérisé en ce que**
les première et deuxième sections (22, 23) des première et deuxième parties extrémité (20, 21) sont respectivement mobiles mutuellement.

2. Ensemble formant échangeur de chaleur à plaques selon la revendication 1, dans lequel la deuxième série de moyens de mise en tension (28) comprend un moyen de compression élastique (32).

3. Ensemble formant échangeur de chaleur à plaques selon l'une quelconque des revendications précédentes, dans lequel la deuxième série de moyens de mise en tension (28) est fournie sous forme de barre de tension, chaque barre de tension étant munie d'un moyen de compression élastique (32).

4. Ensemble formant échangeur de chaleur à plaques selon l'une quelconque des revendications 2 ou 3, dans lequel le moyen de compression élastique (32) est intégré dans les deuxièmes sections (23) des deuxièmes parties extrémité (21).

5. Ensemble formant échangeur de chaleur à plaques selon l'une quelconque des revendications précédentes, dans lequel il n'y a pas de contact métallique entre les première et deuxième sections (22, 23) des première et deuxième parties extrémité (20, 21) du châssis (3).

6. Ensemble formant échangeur de chaleur à plaques selon l'une quelconque des revendications précédentes, dans lequel les panneaux échangeur de chaleur (4) comprennent respectivement des première et deuxième plaques (5) agencées l'une sur l'autre et réunies mutuellement afin de définir un canal de circulation entre celles-ci, ledit canal de circulation étant muni d'un agitateur (13) s'étendant au moins partiellement sur la zone de transfert de chaleur (16) du panneau échangeur de chaleur (4).

7. Ensemble formant échangeur de chaleur à plaques selon la revendication 6, dans lequel les première et deuxième plaques (5) et l'agitateur (13) forment ensemble une structure d'un seul tenant.

8. Ensemble formant échangeur de chaleur à plaques selon l'une quelconque des revendications précédentes, dans lequel la zone d'alimentation de fluide (15) comprend une ouverture d'entrée de fluide (6) et une ouverture de sortie de fluide (7) agencées sur des côtés opposés de la zone de transfert de chaleur (16).

9. Ensemble formant échangeur de chaleur à plaques selon l'une quelconque des revendications précédentes, dans lequel une isolation (19) est agencée entre les panneaux échangeurs de chaleur (4) de l'empilement de plaques (2), ladite isolation (19) comprenant une ouverture traversante (50) accueillant le au moins un dispositif thermoélectrique (17).

10. Ensemble formant échangeur de chaleur à plaques selon l'une quelconque des revendications précédentes, dans lequel les dispositifs thermoélectriques (17) sont des générateurs thermoélectriques.

11. Châssis (3) pour un échangeur de chaleur à plaques sous la forme d'un empilement de plaques (2) comprenant une série de premier et deuxième panneaux échangeurs de chaleur (4), chaque panneau comprenant une zone d'alimentation de fluide (15) et une zone de transfert de chaleur (16), dans lequel au moins un dispositif thermoélectrique (17) est agencé entre deux panneaux échangeurs de chaleur (4) adjacents, dans lequel le châssis (3) comprend une première partie extrémité (20) et une deuxième partie extrémité (21), chaque partie extrémité comprenant une première section (22) et une deuxième section (23), les première et deuxième parties extrémité (20, 21) étant agencées sur des côtés opposés de l'empilement de plaques (2), les premières sections étant agencées en vue d'une compression sur les zones d'alimentation de fluide (15) des panneaux échangeurs de chaleur (4) et les deuxièmes sections (23) étant agencées en vue d'une compression sur les zones de transfert de chaleur (16) des panneaux échangeurs de chaleur (4), et le châssis (3) comprenant en outre une première série de moyens de mise en tension (27) s'étendant entre les premières sections (22) des première et deuxième parties extrémité (20, 21) et une deuxième série de moyens de mise en tension (28) s'étendant entre les deuxièmes sections (23) des première et deuxième parties extrémité (20, 21), **caractérisé en ce que** les première et deuxième sections (22, 23) des première et deuxième parties extrémité (20, 21) sont respectivement mobiles mutuellement.

12. Utilisation d'un ensemble formant échangeur de chaleur à plaques selon l'une quelconque des revendications 1 à 10, dans un moteur à combustion interne en vue d'extraire de l'énergie électrique des gaz d'échappement.
